# EUROPÄISCHE PATENTANMELDUNG

(11) **EP 4 554 343 A1**
(43) Veröffentlichungstag der Anmeldung: **14.05.2025**
(21) Anmeldenummer: 24211617.6
(22) Anmeldetag: 08.11.2024
(51) Int. Cl.: H05K 3/00, B25J 15/04

(54) **VEREINZELUNGSEINRICHTUNG FÜR FLÄCHIGE SUBSTRATE**

(30) Priorität: 10.11.2023 DE 102023131352
(71) Anmelder: ASYS Automatisierungssysteme GmbH, 89160 Dornstadt (DE)
(72) Erfinder: GLATTKY, Volker, 89542 Herbrechtigen (DE); SEMDNER, Marc, 89165 Dietenheim (DE); NAPOLEONE, Philip, 89150 Laichingen (DE)
(74) Vertreter: Clarenbach, Carl-Philipp

(57) **Zusammenfassung**

Die Erfindung betrifft eine Vereinzelungseinrichtung (1) für flächige Substrate, mit einer Halteeinrichtung (3) zum Halten eines flächigen Gesamtsubstrats (14), mit einer Trenneinrichtung (5) zum Lösen zumindest eines Einzelsubstrats (16) aus dem Gesamtsubstrat (14) durch spanende Bearbeitung, mit einer bewegbaren Transporteinrichtung (11) zum Transportieren der Einzelsubstrate (16), mit einer Saugeinrichtung (18) mit zumindest einer der Halteeinrichtung (3) zuordenbaren/zugeordneten Saugöffnung (19) zum Entfernen von beim Zertrennen anfallender Späne und/oder Staub, und mit zumindest einer ringförmigen Bürste (17), wobei die Bürste (17) die Saugöffnung (19) umgibt. Es ist vorgesehen, dass die Bürste (17) lösbar an einem Bürstenhalter (38) gehalten ist, und dass die Transporteinrichtung (9) dazu ausgebildet ist, die Bürste (17) von dem Bürstenhalter (38) zu lösen und/oder an dem Bürstenhalter (38) zu befestigen.

## Beschreibung

Die vorliegende Erfindung betrifft eine Vereinzelungseinrichtung für flächige Substrate, mit einer Halteeinrichtung zum Halten eines flächigen Gesamtsubstrats, mit einer Trenneinrichtung Lösen zumindest eines Einzelsubstrats aus dem Gesamtsubstrat durch spanende, insbesondere fräsende Bearbeitung, mit einer bewegbaren Transporteinrichtung zum Entfernen der Einzelsubstrate, mit einer Saugeinrichtung mit zumindest einer der Haltereinrichtung zuordenbaren Saugöffnung zum Entfernen von beim Zertrennen anfallender Späne und/oder Staub, und mit einer ringförmigen Bürste, wobei die Bürste die Saugöffnung umgibt.

Vereinzelungseinrichtungen der eingangs genannten Art sind aus dem Stand der Technik bereits bekannt. Vereinzelungseinrichtungen (auch Nutzentrenner genannt), sind dazu ausgebildet, beispielsweise aus einem Gesamtsubstrat, auf welchem mehrere elektrische Schaltungen aufgebracht sind, einzelne Leiterplatten mit jeweils einer Schaltung herauszutrennen. Für die Herstellung der Leiterplatten bietet es sich an, mehrere auf einem Gesamtsubstrat herzustellen, um den Transport und die Bearbeitung effizient zu gestalten. Für die spätere Verwendung müssen die Leiterplatten jedoch vereinzelt und dadurch aus dem Gesamtsubstrat herausgetrennt werden. Bei Leiterplatten erfolgt dies in der Regel dadurch, dass diese aus dem Gesamtsubstrat herausgefräst werden. Dabei verfügt das Gesamtsubstrat häufig bereits über Freischnitte in Form von Fräsungen oder Perforierungen, sodass die Einzelsubstrate nur durch übrig gebliebene Verbindungsstege miteinander und/oder mit einem Rahmen des Gesamtsubstrats verbunden sind. In der Vereinzelungseinrichtung werden diese Reststege beispielsweise mithilfe einer Fräseinrichtung entfernt und dadurch die Einzelsubstrate von dem Gesamtsubstrat getrennt. Die herausgetrennten Einzelsubstrate werden mithilfe einer Transporteinrichtung von dem Gesamtsubstrat entfernt und zur weiteren Verwendung abtransportiert. Weil durch die spanende Bearbeitung insbesondere der Reststege Staub und Späne entstehen, ist üblicherweise einer Saugeinrichtung vorhanden, die bei der Bearbeitung beispielsweise unterhalb des Gesamtsubstrats liegt und die Späne oder den Staub während des spanenden Bearbeitungsvorgangs absaugt.

Um den Saugvorgang zu optimieren und die Kontaminierung der Leiterplatten mit Staub oder Spänen zu reduzieren oder ganz zu vermeiden, ist der Sorgevorrichtung außerdem in der Regel eine Bürste zugeordnet, die die Saugöffnung ringförmig umgibt. Im Betrieb liegt die Bürste mit dem Bürstenbesatz an beispielsweise der Unterseite des Gesamtsubstrats an, während die Trenneinrichtung das Substrat bearbeitet. Dadurch entstehen die Späne oder der Staub im Bereich der Bürste und nahe zu der Saugöffnung. Die Bürste verhindert einen Verlust der Saugleistung an der Frässtelle und dass Staub oder Späne aus dem Absaugbereich entweichen. Auch aus gesundheitlichen Gründen ist das Absaugen der Späne und des Staubs von Vorteil.

Der vorliegenden Erfindung liegt die Aufgabe zugrunde, eine verbesserte Vereinzelungseinrichtung zu schaffen, die einen vollautomatisierten Betrieb über einen längeren Zeitraum hinweg ermöglicht, ohne dass eine Person in den Betrieb eingreifen muss.

Die der Erfindung zugrunde liegende Aufgabe wird durch eine Vereinzelungseinrichtung mit den Merkmalen des Anspruchs 1 gelöst. Diese hat den Vorteil, dass die Bürste vollautomatisiert austauschbar ist beziehungsweise ausgetauscht wird. Weist die Bürste Verschleißerscheinungen auf, die dazu führen könnten, dass die Saugleistung der Saugeinrichtung nachlässt und/oder das Staub oder Späne an der Saugeinrichtung vorbei in die Vereinzelungseinrichtung und/oder die Umwelt gelangen können, wird die Bürste automatisiert ausgetauscht. Dazu ist die Bürste lösbar an einem Bürstenhalter gehalten, insbesondere sodass die Bürste einfach und insbesondere werkzeugfrei von dem Bürstenhalter lösbar und an diesem befestigbar ist. Außerdem ist die Transporteinrichtung dazu ausgebildet, die Bürste von dem Bürstenhalter zu lösen und/oder an der Haltereinrichtung befestigen. Die Transporteinrichtung, die üblicherweise zum Entfernen der Einzelsubstrate genutzt wird, wird somit durch eine weitere Funktion ergänzt, nämlich dem Entfernen oder Anordnen einer Bürste von oder an dem Bürstenhalter. Dadurch ist die ohnehin vorhandene Transporteinrichtung vorteilhaft dazu nutzbar, bei Bedarf die Bürste auszutauschen. Das Eingreifen einer Person im Betrieb ist nicht notwendig und ein regelmäßiger Bürstenwechsel kann im laufenden Betrieb der Vereinzelungseinrichtung in kürzester Zeit automatisiert erfolgen, wodurch der Durchsatz der Vereinzelungseinrichtung erhöht und Standzeiten reduziert werden.

Gemäß einer bevorzugten Weiterbildung der Erfindung weist die Transporteinrichtung einen Greifer auf, der dazu ausgebildet ist, die Bürste und/oder ein Einzelsubstrat zu greifen. Mittels des Greifers ist somit die Bürste und/oder das Einzelsubstrat greifbar. Dazu weist der Greifer insbesondere Vorkehrungen auf, die ein sicheres Greifen der Bürste und/oder eines Einzelsubstrats erlauben. Ist der Greifer dazu ausgebildet, sowohl Bürste als auch Einzelsubstrat zu greifen, kann auf einen Austausch des Greifers im laufenden Betrieb verzichtet und dadurch die Austauschzeit für den Wechsel einer Bürste weiter verkürzt werden.

Gemäß einer bevorzugten Weiterbildung der Erfindung weist die Transporteinrichtung eine ansteuerbare Greiferaufnahme zum lösbaren Halten des Greifers auf. Dadurch ist gewährleistet, dass die Transporteinrichtung unterschiedliche Greifer nutzen kann. Insbesondere ist dadurch gewährleistet, dass die Transporteinrichtung einen Greifer für die Einzelsubstrate sowie einen Greifer für die Bürste aufnehmen und bewegen kann. Hierdurch ist eine optimierte Ausbildung der Greifer an die jeweilige Aufgabe ermöglicht.

Insbesondere weist die Vereinzelungseinrichtung einen ersten Greifer zum Greifen eines Einzelsubstrats und einen zweiten Greifer zum Greifen der Bürste auf, wobei die Greiferaufnahme dazu ausgebildet ist, wahlweise den ersten oder den zweiten Greifer zu halten. Somit kann mittels der Transportrichtung, je nachdem, welcher Greifer in oder an der Greiferaufnahme gehalten ist, ein Einzelsubstrat oder eine Bürste transportiert werden.

Vorzugsweise weist zumindest der zweite Greifer, also der Greifer für die Bürste, zwei Greiferteile auf, die jeweils wenigstens einen Greiferfinger aufweisen und relativ zueinander bewegbar sind, um die parallel zueinander ausgerichteten Greiferfinger aufeinander zu oder voneinander weg zu bewegen. Durch das Bewegen oder Verlagern der Greiferteile werden somit die Greiferfinger seitlich zueinander verschoben. Dadurch können die Greiferfinger in eine Position gebracht werden, in welcher die Greiferfinger insbesondere die Bürste kraftschlüssig und/oder formschlüssig greifen sowie in eine Löseposition, in welcher die Greiferfinger die Bürste lösen. Dadurch ist ein sicheres Greifen der Bürste sowie ein sicheres Lösen der Bürste jederzeit gewährleistet.

Vorzugsweise weist jedes Greiferteil zwei parallel zueinander angeordnete Greiferfinger auf. Damit weist der zweite Greifer zumindest vier Greiferfinger auf, die zum Greifen der Bürste genutzt werden. Dadurch ist beim Transport der Bürste eine sichere Lagerung dieser gewährleistet, die ein versehentliches Verlieren oder Lösen der Bürste von dem Greifer verhindert. Optional weist ein Greiferteil nur einen Greiferfinger und das andere Greiferteil zwei Greiferfinger auf, sodass die Bürste durch insgesamt drei Greiferfinger transportierbar ist.

Vorzugsweise weist jeder Greiferfinger an einem freien Ende einen Greiferkopf zum formschlüssigen Zusammenwirken mit der Bürste auf. Durch den Greiferkopf ist die Bürste beispielsweise formschlüssig hintergreifbar, um sie anzuheben oder aus der Bürstenhalterung herauszuziehen. Durch das formschlüssige Zusammenwirken können hohe Kräfte übertragen und dadurch ein sicherer Transport gewährleistet werden.

Gemäß einer bevorzugten Weiterbildung der Erfindung weist die Vereinzelungseinrichtung ein Bürstenmagazin zum Aufnehmen von zumindest zwei Bürsten auf, das der angeordnet ist, dass die Transporteinrichtung eine Bürste in das Bürstenmagazin ablegen und eine Bürste aus dem Bürstenmagazin entnehmen kann. Somit kann der Austausch einer Bürste insbesondere bei Auftreten von Verschleißerscheinungen vollautomatisiert erfolgen, in dem eine Bürste aus dem Magazin entnommen und die bereits genutzte Bürste in dem Magazin abgelegt werden kann. Das Bürstenmagazin weist dazu vorzugsweise mehrere Lagerplätze auf, die eine ringförmige oder reisförmige Vertiefung zur Aufnahme jeweils einer ringförmigen Bürste der Vereinzelungseinrichtung aufweisen. Insbesondere sind die Bürsten der Vereinzelungseinrichtung alle gleich ausgebildet. Alternativ weist die Vereinzelungseinrichtung unterschiedliche, beispielsweise in ihrem Durchmesser unterschiedlich große ringförmige Bürsten auf, wobei dann das Bürstenmagazin für jede Bürstengröße zumindest eine passende Lagerstelle aufweist.

Vorzugsweise ist die Transportrichtung ein Raumportalroboter. Damit weist die Transporteinrichtung mehrere Bewegungsachsen auf, die es erlauben, den Greifer nicht nur in einer Ebene, sondern im Raum der Vereinzelungseinrichtung (dreidimensional) zu bewegen. Darüber hinaus ist die Transporteinrichtung dadurch bauraumsparend in die Vereinzelungseinrichtung integriert.

Gemäß einer bevorzugten Weiterbildung der Erfindung ist die Greiferaufnahme pneumatisch, elektromotorisch, hydraulisch und/oder elektromagnetisch betätigbar, um einen Greifer zu halten und/oder zu lösen. Dadurch ist ein sicherer Transport des Greifers beziehungsweise ein einfacher Austausch der Greifer gewährleistet.

Vorzugsweise weist die jeweilige Bürste einen insbesondere kreisringförmigen Trägerring auf, auf dem ein Bürstenbesatz angeordnet und axial ausgerichtet ist. Damit erstrecken sich insbesondere Bürstenhaare oder Fasern der Bürste in Axialerstreckung der Ringform des Trägerrings. Dadurch ist ein sicheres Umgreifen der Saugöffnung im Betrieb gewährleistet und ein vorteilhaftes Abdichten des Saugbereichs gegenüber der übrigen Vereinzelungseinrichtung.

Vorzugsweise weist der Trägerring an seiner Innen- oder Außenseite zumindest eine Haltevertiefung oder einen Haltevorsprung für den Greiferkopf des jeweiligen Greiferfingers auf. Dadurch ist ein Eingreifen oder Hintergreifen des Trägerrings durch den Greiferkopf vorteilhaft gewährleistet. Vorzugsweise weist der Trägerring mehrere über seinen Umfang verteilt angeordnete Haltevertiefungen und/oder Haltevorsprünge auf.

Gemäß einer bevorzugten Ausführungsform der Erfindung weist der Trägerring an seiner Innenseite eine sich über den gesamten Umfang erstreckende Haltevertiefung, beispielsweise in Form einer Durchmesservergrößerung der Innenseite auf, deren Form mit der Kontur der Greiferköpfe des zweiten Greifers korrespondiert. Dadurch können die Greiferköpfe des zweiten Greifers in diese Haltevertiefung an jeder beliebigen Stelle - im Umfang des Trägerrings gesehen - eingreifen, um die Bürste zu greifen und zu transportieren.

Weiterhin ist bevorzugt vorgesehen, dass der Trägerring an seiner Außen- oder Innenseite zumindest eine Rastvertiefung oder einen Rastvorsprung zum Arretieren der Bürste an dem Bürstenmagazin und/oder an dem Bürstenhalter aufweist. Hierdurch ist eine sichere Befestigung der Bürste an der Saugeinrichtung im Betrieb gewährleistet, ebenso wie im Bürstenmagazin. Dadurch wird verhindert, dass die Bürsten sich versehentlich von ihrer Nutz- oder Lagerposition lösen.

Außerdem ist bevorzugt vorgesehen, dass das Bürstenmagazin und/oder der Bürstenhalter jeweils ein elastisch vorgespanntes Rastelement aufweisen, das dazu ausgebildet ist, mit der Rastvertiefung oder mit dem Rastvorsprung des Trägerrings einer dem Bürstenmagazin oder der Saugeinrichtung zugeführten Bürste zu deren Arretierung zusammenzuwirken. Hierdurch ist das verrastende Halten der Bürste am Bürstenmagazin und/oder an der Saugeinrichtung sicher gewährleistet. Durch das Verrasten ist ein einfaches Lösen und Befestigen ermöglicht, das eine zusätzliche Ansteuerung vermeidet. Insbesondere handelt es sich bei dem Rastelement um ein federbeaufschlagtes Kugelrastelement. Vorzugsweise sind mehrere derartige Rastelemente über den Umfang der Saugeinrichtung beziehungsweise des Bürstenhalters insbesondere gleichmäßig verteilt angeordnet, um die Bürste entlang ihres Außenumfangs zu arretieren.

Weitere Vorteile und bevorzugte Merkmale und Merkmalskombinationen ergeben sich insbesondere aus dem zuvor Beschriebenen sowie aus den Ansprüchen. Im Folgenden soll die Erfindung anhand der Zeichnung näher erläutert werden. Dazu zeigen
- **Figur 1**: eine vorteilhafte Vereinzelungseinrichtung in einer perspektivischen Darstellung,
- **Figur 2**: eine schematische Draufsicht auf einen Teil der Vereinzelungseinrichtung,
- **Figur 3**: eine Saugeinrichtung der Vereinzelungseinrichtung in einer vereinfachten perspektivischen Schnittdarstellung,
- **Figur 4**: einen Greiferfinger eines Greifers der Vereinzelungseinrichtung,
- **Figur 5**: eine vereinfachte Schnittdarstellung eines Greifers der Vereinzelungseinrichtung mit zwei Greiferfingern,
- **Figur 6**: eine perspektivische Darstellung eines Greiferteils eines weiteren Greifers der Vereinzelungseinrichtung in einer perspektivischen Darstellung und
- **Figur 7**: den Greifer aus Figur 6 mit zwei Greiferteilen im Betrieb.

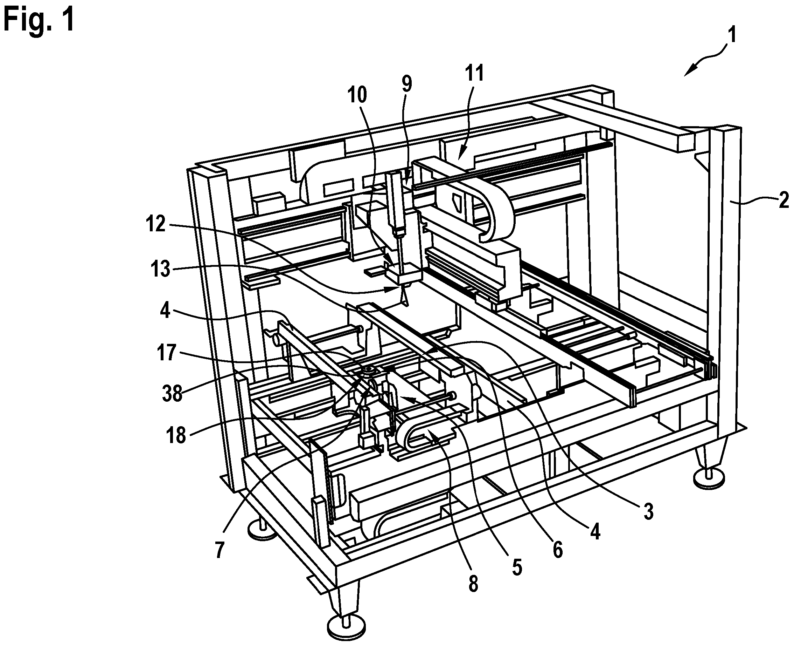

**Figur 1** zeigt in einer schematischen perspektivischen Darstellung eine vorteilhafte Vereinzelungseinrichtung 1, die dazu ausgebildet ist, Einzelsubstrate aus einem flächigen Gesamtsubstrat herauszuteilen. Die Vereinzelungseinrichtungen wird beispielsweise dazu eingesetzt, bei der Leiterplattenherstellung aus einem Leiterplatten-Gesamtsubstrat einzelne Leiterplatten oder Schaltungen herauszutrennen.

Die Vereinzelungseinrichtung 1 weist dazu einen Rahmen 2 auf, an welchem eine Halteeinrichtung 3 zum Halten und Positionieren eines Gesamtsubstrats angeordnet ist. Gemäß dem vorliegenden Ausführungsbeispiel weist die Halteeinrichtung 3 zwei parallel zueinander verlaufende Tragschienen 4 auf, auf welchen das Gesamtsubstrat randseitig aufgelegt wird. Optional sind den Tragschienen 4 Befestigungsmittel zugeordnet, mittels welcher ein Gesamtsubstrat auf den Tagschienen arretierbar ist.

Weiterhin weist die Vereinzelungseinrichtung 1 eine an dem Rahmen 2 gehaltene Trenneinrichtung 5 auf. Die Trenneinrichtung 5 ist dazu ausgebildet, durch spanende Bearbeitung, insbesondere durch fräsende Bearbeitung, aus dem Gesamtsubstrat Einzelsubstrate herauszutrennen. Dazu weist die Trenneinrichtung 5 einen Bearbeitungskopf 6 auf, der insbesondere als Fräskopf mit einem Fräswerkzeug 7 ausgebildet ist. Vorzugsweise ist der Fräskopf 6 an einem Raumportalroboter 8 gehalten, durch welchen den Fräskopf 6 innerhalb des Rahmens 2 in x-, y- und z-Richtung, also dreidimensional bewegt werden kann. Der Fräskopf 6 liegt dabei unterhalb oder zumindest im Wesentlichen unterhalb der Halteeinrichtung 3beziehungsweise der Tragschienen 4, um das Gesamtsubstrat von unten zu bearbeiten.

Oberhalb der Halteeinrichtung 3 weist die Vereinzelungseinrichtung 1 eine Transporteinrichtung 9 auf, die eine Greiferaufnahme 10 aufweist, die durch einen weiteren Raumportalroboter 11 im Raum des Rahmens 2 dreidimensional verlagerbar ist. Dabei ist der Raumportalroboter 11 derart ausgebildet, dass die Greiferaufnahme 10 auch aus dem Raum des Rahmens 2 hinaus, beispielsweise in ein neben der Vereinzelungseinrichtung 1 stehendes Lager, bewegbar ist. Dazu führt zumindest eine Transportschiene des Raumportalroboters 11 aus dem Rahmen 2 heraus, wie in Figur 1 beispielhaft gezeigt. An der Greiferaufnahme 10 ist vorliegend ein Greifer 12 lösbar gehalten, der einen oder mehrere Greiferfinger 13 aufweist.

Die Vereinzelungseinrichtung 1 ist dazu ausgebildet, mittels der Trenneinrichtung 5 zunächst ein Einzelsubstrat aus dem Gesamtsubstrat zu lösen und dieses mittels der Transportrichtung 9 vom Gesamtsubstrat zu entfernen und abzutransportieren, beispielsweise in das oben bereits genannte Lager, um es dort abzulegen oder zur weiteren Bearbeitung zur Verfügung zu stellen.

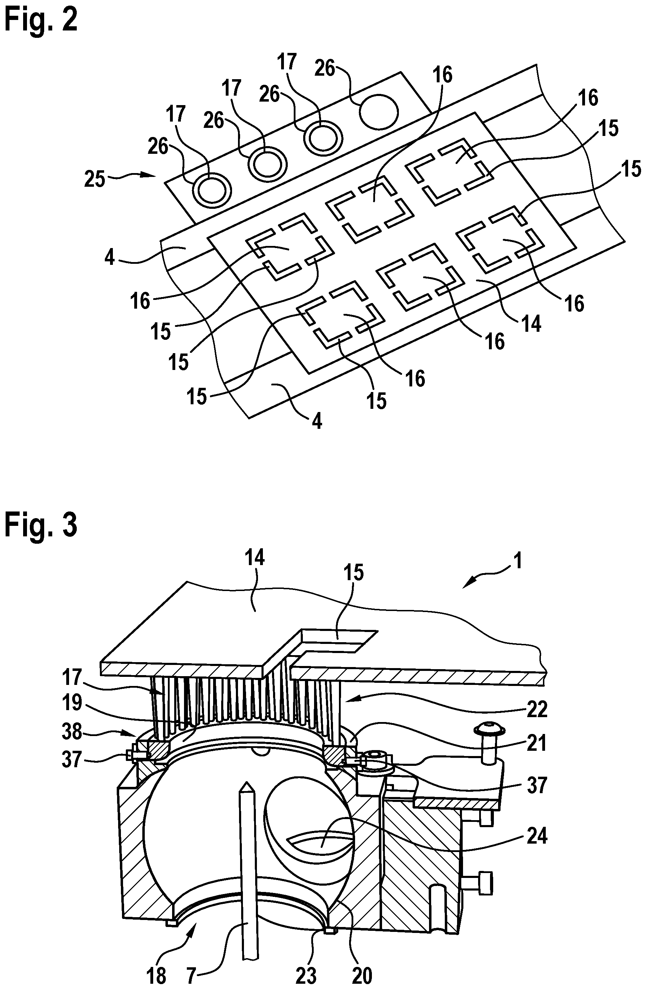

**Figur 2** zeigt in einer vereinfachten Draufsicht ein auf den Tragschienen 4 abgelegtes Gesamtsubstrat 14. Üblicherweise sind in dem Gesamtsubstrat 14 durch Freischnitte 15 die Einzelsubstrate 16 bereits größtenteils von dem Gesamtsubstrat 14 getrennt und werden lediglich noch durch verbliebene Verbindungsstege an dem Gesamtsubstrat 14 oder aneinander gehalten. Dadurch ist der in der Vereinzelungseinrichtung 1 durchzuführende Trennprozess mit einem geringen Aufwand verbunden. Dennoch werden beim Auftrennen der Verbindungsstege Staub und Späne erzeugt, die ungünstig für die Gesundheit von in der Nähe der Vereinzelungseinrichtung befindlichen Personen und ungünstig für die Leiterplatten oder Einzelsubstrate selbst sein können, wenn sie sich auf diesen ablagern.

Aus diesem Grund ist der Trenneinrichtung 5 weiterhin eine kreisringförmige Bürste 17 zugeordnet, die in den Fräskopf 6, zumindest aber Fräser 7 bei der Bearbeitung des Gesamtsubstrats 14 umgibt. Die Bürste 17 ist dabei an einer Saugeinrichtung 18 angeordnet, die eine in Figur 1 nicht ersichtliche Saugöffnung 19 innerhalb der Bürste 17 aufweist, um Späne und Staub, die bei der Bearbeitung durch den Fräser 7 anfallen, abzusaugen.

**Figur 3** zeigt hierzu in einer vereinfachten Schnittdarstellung die Vereinzelungseinrichtung 1 im Bereich der Saugeinrichtung 18. Die Saugeinrichtung18 weist eine Saugglocke 20 oder -kugel auf, die den Tragschienen 4 beziehungsweise dem Gesamtsubstrat 14 zugeordnet die Saugöffnung 19 aufweist. Die Bürste 17 umgibt die Saugöffnung 19 vollständig beziehungsweise bildet die Saugöffnung 19 mit aus. Dazu weist die Bürste 17 einen Trägerring 21 auf, der durch einen Bürstenhalter 38 an der Saugglocke 20 befestigt ist. An dem Trägerring 21 ist ein Bürstenbesatz 22 angeordnet, der in Richtung des Gesamtsubstrats 14 beziehungsweise in Richtung der Halteeinrichtung 3 an den Tragschienen 4 hervorsteht, um von unten gegen das zu bearbeitende Trägersubstrat 14 gerückt werden zu können. Der Bürstenbesatz 22 ist ebenfalls über den gesamten Umfang des Trägerrings 21 angeordnet, und bildet somit einen kreisringförmig und in Umfangsrichtung geschlossenen Bürstenbesatz 22 aus. Der Bürstenbesatz 22 umgibt insoweit ebenfalls die Saugöffnung 19.

Auf der von der Saugöffnung 19 abgewandten Seite weist die Saugglocke 20 eine Eintrittsöffnung 23 für den zuvor genannten Fräser 7 auf. Dadurch ist der Fräser 7 in oder durch den Trägerring 21 hindurch führbar, um das Gesamtsubstrat 14 zu bearbeiten. Anfallende Späne werden somit innerhalb des Trägerrings 21 beziehungsweise der Bürste 17 aufgenommen und durch die Saugeinrichtung 18 abgesaugt. Dazu weist die Saugglocke 20 eine weitere Öffnung 24 auf, die mit einer Saugpumpe verbindbar oder verbunden ist, um einen Sog innerhalb der Bürste 17 zu erzeugen. Dadurch, dass die Bürste 17 beim Bearbeiten des Gesamtsubstrats 14 an diesem anliegt, werden Späne und Staub daran gehindert, von der Saugglocke 20 zu entweichen. Vielmehr werden Staub und Späne direkt durch die Saugeinrichtung 18 abgesaugt. Weil beim Verschieben der Fräseinrichtung 6 die Bürste 17 mit dem Fräser 7 mitbewegt wird und damit an der Unterseite des Gesamtsubstrats 14 entlangstreicht, werden außerdem an dem Gesamtsubstrat haftende Späne oder Staub ebenfalls entfernt.

Dadurch entsteht im Betrieb jedoch Verschleiß an der Bürste 17, wodurch die Dichtwirkung der Bürste 17 mit der Zeit nachlassen kann.

Die vorteilhafte Vereinzelungseinrichtung 1 weist daher ein Magazin 25 auf, in welchem mehrere gleich ausgebildete Bürsten 17 gehalten sind. Dazu weist das Magazin 25 mehrere Lagerplätze 26 auf, in denen jeweils eine Bürste 17 anordenbar und insbesondere arretierbar ist. Vorzugsweise ist zumindest einer der Lagerplätze 26 leer beziehungsweise nicht besetzt, sodass dort eine verbrauchte oder von Verschleiß gezeichnete Bürste 17 ablegbar ist.

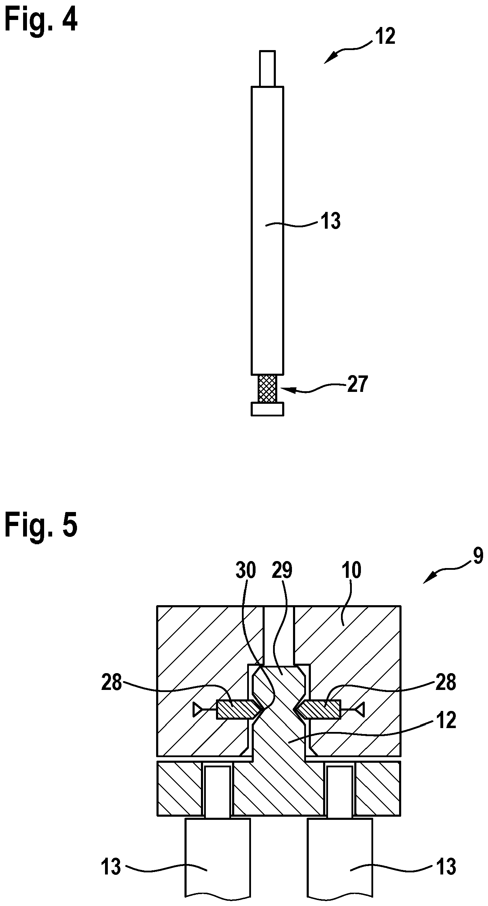

**Figur 4** zeigt hierzu einen beispielhaften Greiferfinger 13, der dazu dient, ein Einzelsubstrat von dem Gesamtsubstrat 14 zu entfernen. Dazu weist der Greiferfinger 13 an seinem freien Ende einen Halteabschnitt 27 auf, mittels dessen er durch einen der Freischnitte hindurchführbar ist, um das jeweilige Einzelsubstrat 16 formschlüssig zu hintergreifen und nach dem Entfernen der Verbindungsstege anzuheben und dadurch von dem Gesamtsubstrat 14 zu lösen. Der Halteabschnitt 27 weist dazu einen verjüngten Durchmesser im Vergleich zu dem übrigen Greiferfinger 13 auf, wobei der Halteabschnitt optional mit einem vorteilhaften Material beschichtet ist, insbesondere mit einer Diamantbeschichtung, das eine Beschädigung des Einzelsubstrats verhindert und gleichzeitig eine sichere Halterung des Einzelsubstrats 16 gewährleistet. Zweckmäßigerweise weist der Greifer 12 mehrere derartige Greiferfinger 13 auf, um das Einzelsubstrat 16 sicher zu halten und zu transportieren.

**Figur 5** zeigt eine vereinfachte Schnittdarstellung der Transporteinrichtung 9 im Bereich der Greiferaufnahme 10. Die Greiferaufnahme 10 weist eine Vertiefung auf, welcher insbesondere pneumatisch verlagerbare Arretierelemente 28 zugeordnet sind, die mit dem Greifer 13 zusammenwirken. Dazu weist der Greifer 13 einen Arretierungszapfen 29 auf, der in die Vertiefung der Greiferaufnahme 10 einführbar und dort durch die Arretierelemente 28 formschlüssig haltbar ist. Dazu weist der Arretierzapfen 29 eine Durchmesserverjüngung 30 auf, in welche die Arretierelemente 28 einschiebbar sind, um den Greifer 12 formschlüssig an der Greiferaufnahme 10 zu arretieren. Wie in dem Ausführungsbeispiel von **Figur 5** gezeigt, sind an dem Greifer 12 zwei der Greiferfinger 13 gehalten.

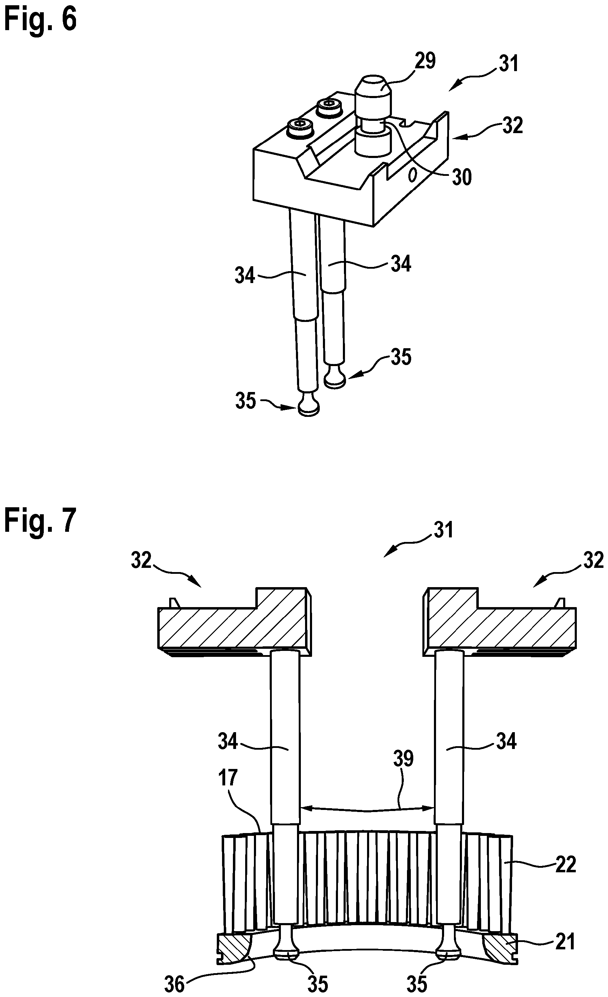

Die Vereinzelungseinrichtung 1 weist einen weiteren Greifer 31 auf, der beispielhaft in **Figuren 6 und 7** näher erläutert wird. Der Greifer 31 weist zwei Greiferteile 32 auf, die gleich, insbesondere identisch zueinander ausgebildet sind. Beide Greiferteile 32 weisen einen Arretierzapfen 33 auf, der dem Arretierzapfen 29 entspricht, um in jeweils einer Vertiefung der Greiferaufnahme 10, wie zuvor beschrieben, mittels jeweiligen Arretierelemente28lösbar arretiert werden zu können. Außerdem sind an jedem Greiferteil 32 zwei Greiferfinger 34 angeordnet. Die Greiferfinger 34 unterscheiden sich von den Greiferfingern 13 dadurch, dass an ihren freien Enden nicht der Halteabschnitt 27 ausgebildet ist, sondern ein Greiferkopf 35, der dazu ausgebildet ist, mit der Bürste 17, insbesondere mit dem Trägerring 21 der Bürste 17, formschlüssig zusammenzuwirken.

Dazu weist der jeweilige Greiferkopf 35 eine Kontur auf, die der Form der Innenseite des Trägerrings 21 zumindest im Wesentlichen entspricht. Wie in **Figur 6** gezeigt, ist dadurch der jeweilige Greiferfinger 34 mit dem Greiferkopf 35 vorteilhaft an der Innenseite des Trägerrings 21 insbesondere flächig anlegbar. Der Trägerring 21 weist dabei beispielsweise eine nutförmige Vertiefung oder, wie in dem vorliegenden Ausführungsbeispiel, eine sich über den Umfang erstreckende Durchmessererweiterung oder -vergrößerung 36 an seiner Innenseite auf, wobei sich der Durchmesser von der dem Bürstenbesatz 22 abgewandten Seite des Trägerrings 21 aufweitet.

Durch die angepasste Kontur der Greiferköpfe 35 können diese den Trägerring 21 vorteilhaft hintergreifen, wenn die Greiferfinger 34, wie in **Figur 7** gezeigt, von oben beziehungsweise von der Saugeinrichtung 18 abgewandten Seite in die Bürste 17 eingeführt und anschließend radial zu der Bürste nach außen bewegt werden, wie durch einen Pfeil 39 in **Figur 7** gezeigt. Der Greifer weist, wie oben bereits erwähnt, zwei der Greiferteile 32 auf. Beide Greiferteile 32 sind in Figur 7 gezeigt. Die Transporteinrichtung 9 ist dazu ausgebildet, die Greiferteile 32 aufeinander zu und voneinander weg zu bewegen, wodurch die Greiferköpfe 35 in eine Freigabeposition und in eine den Trägerring 21 hintergreifende Position, wie in **Figur 7** gezeigt, verlagerbar sind. Weil der Greifer durch den Raumportalroboter 11, können die Greiferteile 32 auch in der Höhe verlagert werden, um in die Bürste 17 eingeführt oder aus der Bürste 17 herausgezogen zu werden, und um das Bürstenmagazin 25 anzufahren.

Vorzugsweise weist die Greiferaufnahme 10 zwei Vertiefungen auf, wobei in jeder Vertiefung jeweils eines der Greiferteile 32 arretierbar ist, wie in **Figur 5** an einem Greiferteil 31 beispielhaft gezeigt.

Auch die Greiferfinger 13 werden vorteilhafterweise paarweise an Greiferteilen gehalten, die in jeweils einer der Vertiefungen der Greiferaufnahme 10 haltbar und arretierbar sind. Die Vertiefungen sind in jeweils einem Aufnahmeteil der Greiferaufnahme 10 ausgebildet, wobei die Aufnahmeteile relativ zueinander verlagerbar, insbesondere aufeinander zu und voneinander weg bewegbar sind, um die obenstehend beschriebenen Funktionen auszuführen. Dadurch lassen sich auch die Einzelsubstrate 16 mittels der Greiferfinger 13 vorteilhaft greifen und transportieren. Dadurch, dass die vorteilhafte Vereinzelungseinrichtung 1 nunmehr zwei Arten von Greifern 31, 12 aufweist, die austauschbar ausgebildet und somit wahlweise von der Transporteinrichtung 9 genutzt werden können, ist es mit der vorteilhaften Vereinzelungseinrichtung 1 möglich, sowohl die Einzelsubstrate 16 als auch die Bürsten 17 zu transportieren und insbesondere die Bürsten 17 auszutauschen. So wird bei erkanntem Verschleiß der aktuell verwendeten Bürste 17 diese durch die Transporteinrichtung 9 in einem freien Lagerplatz 26 des Magazins 25 abgelegt und die Greiferfinger 34 in eine in einem anderen der Lagerplätze 26 des Bürstenmagazins 25 vorgehaltene und unbenutzte Bürste 17 eingeführt, um diese auf der Bürstenhalter 38 der Saugeinrichtung 18 zu befestigen.

Vorzugsweise weist der Bürstenhalter 38 an elastisch vorgespannte Rastelemente 37 auf, wie in **Figur 3** beispielhaft gezeigt, die mit dem Trägerring 21, insbesondere mit dessen Außenseite, zu seiner lösbaren Befestigung zusammenwirken. So sind die Rastelemente 37 beispielsweise dazu ausgebildet, dass sie entgegen einer Federkraft nach außen verlagert werden, wenn der Trägerring 21 auf die Saugglocke 20 aufgelegt wird, um anschließend den Trägerring zumindest bereichsweise beim Zurückfedern zu hintergreifen und damit einzurasten. Dadurch ist die Bürste 17 formschlüssig an der Saugglocke 20 beziehungsweise an dem Bürstenhalter 38 arretiert. Wird die Bürste 17 von den Greiferköpfen 35 mittels der Transportrichtung hintergriffen, um sie von der Saugglocke 20 zu lösen, wird auf gleiche Weise das jeweilige Rastelement 37 radial nach außen entgegen Federkraft verlagert und dadurch die Bürste 17 vorteilhaft von dem Bürstenhalter 38 gelöst. Die Rastelemente 37 weisen dazu vorteilhafterweise eine mit dem Trägerring 21 zusammenwirkende Rastkugel oder dergleichen auf, die ein Zurückdrängen entgegen der Federkraft beim Verlagern der Bürste bewirken. Optional sind derartige Rastelemente 37 auch an den Lagerplätze 26 des Magazins 25 angeordnet, um eine sichere Arretierung der Bürsten 17 in den Lagerplätze 26 zu ermöglichen.

Die Transportrichtung 9 ist insbesondere dazu ausgebildet, sowohl die Arretierelemente 28 als auch die Greiferteile 32 pneumatisch zu verschieben. Entsprechend sind jedem Greiferteile 32 jeweils ein pneumatischer Aktuator oder ein gemeinsamer Aktuator zugeordnet, mittels dessen die Greiferteile 32 und damit die Greiferfinger 34 relativ zueinander verschiebbar sind, um eine Bürste 17 zu hintergreifen oder freizugeben.

Vorzugsweise weist die Vereinzelungseinrichtung 1 ein Greifermagazin auf, in welchem die unterschiedlichen Greifer 12 und 31 lagerbar sind. Damit ist es der Transportrichtung 9 möglich, ohne manuelle Unterstützung auch die Greiferfinger oder Greifer 31, 12 automatisiert auszutauschen.

Insgesamt ist somit die Vereinzelungseinrichtung 1 dazu ausgebildet, vollautomatisiert eine Vereinzelung und den Austausch der Bürste 17 durchzuführen. Dadurch können Standzeiten reduziert und der Durchsatz der Vereinzelungseinrichtung 1 erhöht werden. Gleichzeitig wird eine hohe Qualität der Bearbeitung gewährleistet.

## Patentansprüche

1. Vereinzelungseinrichtung (1) für flächige Substrate, mit einer Halteeinrichtung (3) zum Halten eines flächigen Gesamtsubstrats (14), mit einer Trenneinrichtung (5) zum Lösen zumindest eines Einzelsubstrats (16) aus dem Gesamtsubstrat (14) durch spanende Bearbeitung, mit einer bewegbaren Transporteinrichtung (11) zum Transportieren der Einzelsubstrate (16), mit einer Saugeinrichtung (18) mit zumindest einer der Halteeinrichtung (3) zuordenbaren/zugeordneten Saugöffnung (19) zum Entfernen von beim Zertrennen anfallender Späne und/oder Staub, und mit zumindest einer ringförmigen Bürste (17), wobei die Bürste (17) die Saugöffnung (19) umgibt, **dadurch gekennzeichnet, dass** die Bürste (17) lösbar an einem Bürstenhalter (38) gehalten ist, und dass die Transporteinrichtung (9) dazu ausgebildet ist, die Bürste (17) von dem Bürstenhalter (38) zu lösen und/oder an dem Bürstenhalter (38) zu befestigen.

2. Vereinzelungseinrichtung nach Anspruch 1, **dadurch gekennzeichnet, dass** die Transporteinrichtung (9) zumindest einen Greifer (12,31) aufweist, der dazu ausgebildet ist, die Bürste (17) und/oder ein Einzelsubstrat (16) zu greifen.

3. Vereinzelungseinrichtung nach einem der vorhergehenden Ansprüche, **dadurch gekennzeichnet, dass** die Transporteinrichtung (9) eine ansteuerbare Greiferaufnahme (10) zum lösbaren Halten des Greifers (12,31) aufweist.

4. Vereinzelungseinrichtung nach einem der vorhergehenden Ansprüche, **dadurch gekennzeichnet, dass** ein erster Greifer (12) zum Greifen eines Einzelsubstrats und ein zweiter Greifer (31) zum Greifen der Bürste (17) vorhanden ist, wobei die Greiferaufnahme (10) dazu ausgebildet ist, wahlweise den ersten oder den zweiten Greifer (12,31) zu halten.

5. Vereinzelungseinrichtung nach einem der vorhergehenden Ansprüche, **dadurch gekennzeichnet, dass** zumindest der zweite Greifer (31) zwei Greiferteile (32) aufweist, die jeweils wenigstens einen Greiferfinger (34) aufweisen und relativ zueinander bewegbar sind, um die insbesondere parallel zueinander ausgerichteten Greiferfinger (34) aufeinander zu oder voneinander weg zu bewegen.

6. Vereinzelungseinrichtung Anspruch 5, **dadurch gekennzeichnet, dass** jedes Greiferteil (32) zwei parallel zueinander angeordnete Greiferfinger (34) aufweist.

7. Vereinzelungseinrichtung nach einem der vorhergehenden Ansprüche, **dadurch gekennzeichnet, dass** jeder Greiferfinger (34) an einem freien Ende einen Greiferkopf (35) zum formschlüssigen Zusammenwirken mit der Bürste (17) aufweist.

8. Vereinzelungseinrichtung nach einem der vorhergehenden Ansprüche, **dadurch gekennzeichnet, dass** ein Bürstenmagazin (25) zum Aufnehmen von zumindest zwei Bürsten (17) vorhanden und derart angeordnet ist, dass die Transporteinrichtung (9) eine Bürste (17) in das Bürstenmagazin (25) ablegen und eine Bürste (17) aus dem Bürstenmagazin (25) entnehmen kann.

9. Vereinzelungseinrichtung nach einem der vorhergehenden Ansprüche, **dadurch gekennzeichnet, dass** die Transporteinrichtung (9) ein Raumportalroboter (11) ist.

10. Vereinzelungseinrichtung nach einem der vorhergehenden Ansprüche, **dadurch gekennzeichnet, dass** die Greiferaufnahme (10) pneumatisch, elektromotorisch, hydraulisch und/oder elektromagnetisch betätigbar ist, um den oder einen der Greifer (12,31) zu halten und/oder zu lösen.

11. Vereinzelungseinrichtung nach einem der vorhergehenden Ansprüche, **dadurch gekennzeichnet, dass** die Bürste (17) einen insbesondere kreisringförmigen Trägerring (21) aufweist, auf dem ein Bürstenbesatz (22) angeordnet und axial ausgerichtet ist.

12. Vereinzelungseinrichtung nach einem der vorhergehenden Ansprüche, **dadurch gekennzeichnet, dass** der Trägerring (21) an seiner Innen- oder Außenseite zumindest eine Haltevertiefung oder einen Haltevorsprung für den Greiferkopf (35) des jeweiligen Greiferfingers (34) aufweist.

13. Vereinzelungseinrichtung nach einem der vorhergehenden Ansprüche, **dadurch gekennzeichnet, dass** der Trägerring (21) an seiner Innenseite eine sich über den gesamten Umfang erstreckende Durchmesservergrößerung aufweist, deren Form mit der Kontur der Greiferköpfe (35) des zweiten Greifers (31) korrespondiert.

14. Vereinzelungseinrichtung nach einem der vorhergehenden Ansprüche, **dadurch gekennzeichnet, dass** der Trägerring (21) an seiner Außen- oder Innenseite zumindest eine Rastvertiefung oder einen Rastvorsprung zur Arretierung an dem Bürstenmagazin (25) und/oder an dem Bürstenhalter (38) aufweist.

15. Vereinzelungseinrichtung nach einem der vorhergehenden Ansprüche, **dadurch gekennzeichnet, dass** das Bürstenmagazin (25) und/oder der Bürstenhalter (38) jeweils mindestens ein elastisch vorgespanntes Rastelement (37) aufweisen, das dazu ausgebildet ist, mit dem Trägerring (21), insbesondere mit der Rastvertiefung oder dem Rastvorsprung des Trägerrings (21), einer/der dem Bürstenmagazin (25) oder dem Bürstenhalter (38) zugeführten Bürste (17) zu deren Arretierung zusammen zu wirken.
